Europäisches Patentamt

European Patent Office

Office européen des brevets

(19)

(11) Numéro de publication : **0 407 253 B1**

(12) **FASCICULE DE BREVET EUROPEEN**

(45) Date de publication du fascicule du brevet :
27.04.94 Bulletin 94/17

(21) Numéro de dépôt : 90401717.5

(22) Date de dépôt : 19.06.90

(51) Int. Cl.⁵ : **H02P 6/02**

(54) **Dispositif de mesure dynamique du couple d'un moteur autosynchrone et dispositif de commande asservie d'un moteur autosynchrone utilisant ce dispositif.**

(30) Priorité : **07.07.89 FR 8909173**

(43) Date de publication de la demande :
**09.01.91 Bulletin 91/02**

(45) Mention de la délivrance du brevet :
**27.04.94 Bulletin 94/17**

(84) Etats contractants désignés :
**DE GB IT NL**

(56) Documents cités :
**EP-A- 0 254 310**
**US-A- 4 490 661**
**US-A- 4 651 068**
**CONFERENCE RECORD INDUSTRY APPLICA-
TIONS SOCIETY IEEE-IAS-1985 ANNUAL
MEETING 1985 octobre 1985, pages 790 - 797;
H. LE-HUY ET AL: "MINIMIZATION OF TOR-
QUE RIPPLE IN BRUSHLESS DC MOTOR DRI-
VES"**

(56) Documents cités :
**PROCEEDINGS IECON '87 novembre 1987, US
pages 454 - 463; B.K. BOSE ET AL: "A MICRO-
COMPUTER-BASED CONTROL AND SIMULA-
TION OF AN ADVANCED IPM SYNCHRONOUS
MACHINE DRIVE SYSTEM FOR ELECTRIC
VEHICLE PROPULSION"**
**PATENT ABSTRACTS OF JAPAN vol. 4, no. 32
(E-2)(514) 19 mars 1980, & JP-A-55 005012
(NIPPON DENSHIN DENWA KOSHA) 14 janvier 1980,**

(73) Titulaire : **THOMSON-CSF**
**173, Boulevard Haussmann**
**F-75008 Paris (FR)**

(72) Inventeur : **Bardelang, Vianney**
**Thomson-CSF, SPCI, Cédex 67**
**F-92045 Paris La Défense (FR)**
Inventeur : **Coeuillet, Jacques**
**Thomson-CSF, SPCI, Cédex 67**
**F-92045 Paris La Défense (FR)**
Inventeur : **Dubos, Pascal**
**Thomson-CSF, SPCI, Cédex 67**
**F-92045 Paris La Défense (FR)**

(74) Mandataire : **Albert, Claude et al**
**THOMSON-CSF SCPI B.P. 329 50, rue J.P.
Timbaud**
**F-92402 COURBEVOIE CEDEX (FR)**

EP 0 407 253 B1

**Description**

La présente invention se rapporte à un dispositif de mesure dynamique du couple d'un moteur autosynchrone. Elle se rapporte également, à un dispositif de commande asservie d'un moteur autosynchrone, ce dispositif de commande utilisant ce dispositif de mesure dynamique.

Les moteurs autosynchrones sont des moteurs d'un bon rapport puissance/poids, qui sont de plus en plus utilisés dans la réalisation des servomécanismes, où ils tendent à remplacer progressivement les moteurs à courant continu utilisés jusqu'alors.

Un moteur autosynchrone a la même structure électromagnétique qu'un moteur synchrone classique. Son rotor est généralement composé d'un aimant permanent, tandis que son stator est polyphasé, par exemple triphasé et comportant en conséquence trois enroulements d'induit montés en étoile.

En fait, la ressemblance avec le moteur synchrone s'arrête là, car le mode de fonctionnement d'un moteur autosynchrone est tout autre. Il consiste en effet à alimenter en courants les enroulements d'induit précités de façon que le champ magnétique instantané qui résulte de la combinaison de ces courants soit toujours perpendiculaire au moment magnétique de l'aimant constituant le rotor ou, en d'autres termes, parallèle à l'"APMM" ("Axe Perpendiculaire au Moment Magnétique de l'aimant").

Dans le cas d'une configuration triphasée des enroulements d'induit, on démontre aisément que cette condition est réalisée en alimentant respectivement le premier, le deuxième, et le troisième enroulement d'induit par des courants qui sont obtenus en multipliant le signal, ou paramètre, de commande du moteur (souvent dénommé "courant commandé") par respectivement une valeur proportionnelle à cos A, cos (A+120°) et cos (A-120°), où "A" est l'angle électrique entre le premier enroulement d'induit et l'APMM précités.

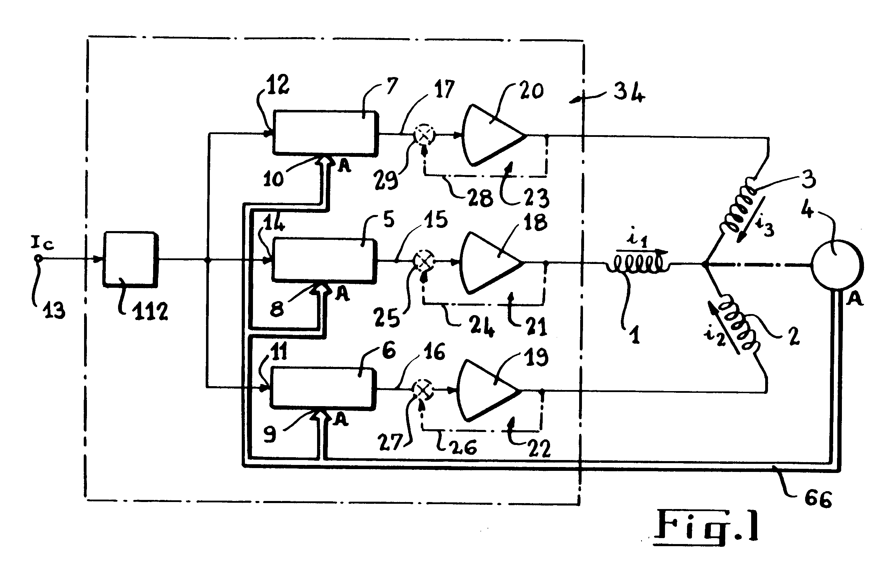

La figure 1 jointe représente, à titre indicatif, un dispositif classique de commande d'un moteur autosynchrone. Sur cette figure, les références 1, 2 et 3 représentent respectivement les trois enroulements statoriques triphasés du moteur autosynchrone, qui sont respectivement parcourus par les courants instantanés i1, i2, i3.

L'angle électrique A entre l'APMM et l'enroulement 1 est mesuré par un capteur 4, et il est appliqué respectivement aux trois premières entrées 8, 9, 10 de circuits de calcul 5, 6, 7 qui reçoivent respectivement, sur leurs trois secondes entrées 14, 11, 12, un signal égal au paramètre de commande, dit "courant commandé", Ic appliqué à l'entrée de commande 13 et multiplié par un facteur de normalisation dans un multiplieur 112.

Le circuit 5 réalise le calcul de cos A et sa multiplication par la valeur analogique du signal en 14. Le circuit 6 réalise le calcul de cos (A-120°) et sa multiplication par la valeur analogique du signal en 11, et pareillement le circuit 7 réalise le calcul de cos (A+120°) et sa multiplication par la valeur analogique du signal en 12. Sur les sorties 15, 16, 17 de ces trois circuits apparaissent des tensions analogiques qui sont respectivement proportionnelles à Ic.cos A, Ic.cos (A-120°), et Ic.cos (A+120°), ce qui correspond bien à la répartition souhaitée pour les trois courants d'induit i1, i2, et i3.

Ces trois tensions analogiques attaquent respectivement trois amplificateurs de puissance 18, 19, et 20, qui fournissent eux-mêmes les courants i1, i2, et i3 aux enroulements statoriques triphasés 1, 2, et 3.

Un tel moteur autosynchrone présente, pour un coût compétitif, de multiples avantages :
. forte puissance massique
. taux de puissance élevé
. possibilité de hautes vitesses
. bonne régularité des vitesses lentes
. longue durée de vie
. facilité de maintenance.

En revanche, ces moteurs étant des machines alternatives polyphasées, il n'existe pas, comme c'est le cas pour le courant d'induit des moteurs à courant continu, de signal matérialisé qui puisse être considéré comme une image directe de leur couple électromagnétique. Or, dans les servomécanismes, il est particulièrement intéressant de disposer d'un moyen assurant un contrôle du couple au niveau de l'axe moteur, ce contrôle devant être de qualité.

Par exemple, il est souvent nécessaire :
. d'atténuer l'effet des non-linéarités des amplificateurs (dont les seuils) ;
. de limiter la valeur maximale du couple appliqué à la charge ;
. de fidéliser la fonction de transfert du couple.

Par ailleurs, le technicien ne disposant pas d'image en temps réel du couple électromagnétique du moteur autosynchrone, n'a pas la possibilité, lors des essais de mise au point en laboratoire, d'effectuer des mesures sur cette grandeur et , en particulier, d'établir la fonction de transfert de couple.

Le problème du contrôle du couple d'un moteur autosynchrone est d'autant plus critique à résoudre que ces machines, en raison de l'inductance non négligeable des enroulements statoriques, tendent à opposer une impédance réactive non négligeable, cette réaction étant d'autant plus importante que la vitesse est élevée, ce qui se traduit par une diminution du couple électromagnétique lorsque la vitesse augmente.

En effet, le couple électromagnétique des moteurs autosynchrones étant naturellement égal au produit vectoriel du vecteur "champ tournant" créé par les enroulements statoriques polyphasés par le vecteur "moment magnétique" du rotor, si par exemple la direction du champ d'induction créé par ces enroulements est réglée pour être, à l'arrêt du moteur (vitesse nulle), parallèle à l'APMM, le déphasage inductif crée lorsque le moteur tourne, dans les bobine statoriques, produit alors nécessairement un déphasage spatial corrélatif du champ d'induction précité, de sorte que ce dernier cesse d'être parallèle à l'APMM, ce qui entraîne une réduction du couple, cette réduction variant comme le cosinus de l'angle de déphasage spatial précité.

Pour lutter contre cet effet néfaste de l'inductance des enroulements d'induit, deux moyens sont couramment utilisés:

Un premier moyen consiste à effectuer une "compensation a priori", qui est réalisée en temps réel en fonction des courants d'induit et de la vitesse de rotation du moteur. Elle consiste, connaissant la valeur de l'inductance de chaque enroulement statorique, à lui appliquer, à travers l'amplificateur de puissance qui lui est associé, une augmentation de tension d'autant plus élevée que la vitesse de rotation du moteur est grande, afin de compenser les chutes de tension selfiques.

Un exemple d'un tel dispositif est connu du brevet EP-A-0 254 310. La figure 6 de ce brevet montre un dispositif dans lequel à partir de la vitesse mesurée $w_r$ du moteur on ajoute des courants de correction $\Delta i_{1q}$ et $\Delta i_{1d}$ respectivement, à des courants de commande $I_{1q}$ et $I_{1d}$ du couple et du flux. Les valeurs de correction des courants de commande sont calculées a priori à partir de la connaissance de la valeur $L_2$ des enroulements secondaires, des valeurs de commande et d'autres caractéristiques connues a priori du moteur.

Le mode particulier de réalisation de la figure 6 comporte en outre une correction additionnelle de courant (27) destinée à supprimer des variations périodiques en position du couple. Ces variations correspondent aux harmoniques $2f_1$ et $6kf_1$ de la fréquence du courant d'alimentation $i_1$.

Bien que les figures 1 ou 6 de ce brevet aient l'apparence d'une boucle de réaction, il ne s'agit en fait que de la mesure d'un paramétre, la valeur de la vitesse de rotation pour corriger une commande par des valeurs calculées a priori en fonction de cette vitesse et d'autre valeurs connues a priori, du moteur.

Un autre exemple de courant de correction est connu du document "Conference Record Industry Application Society -IEEE - IAS - 1985 Annual Meeting 1985 - October 1985 page 790 - 797 ; H. LE-HUY et Al". "Minimization of torque ripple in brushless DC Drives".

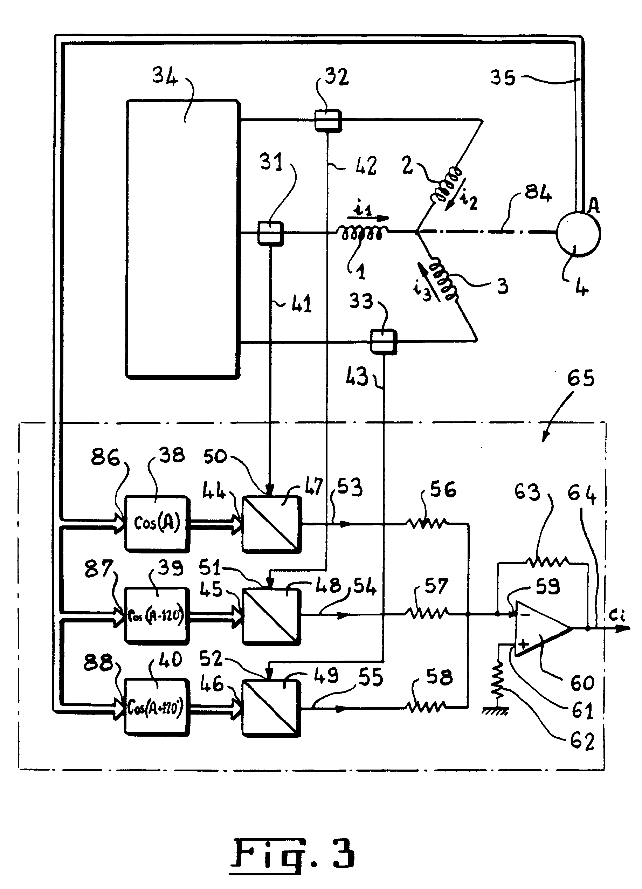

Ce document explique comment il est possible de minimiser les variations périodiques de couple en particulier celles dues aux harmoniques 6 et 12 du courant d'alimentation en injectant des courants additionnels. Le procédé est applicable en particulier à un moteur tel que celui représenté figure 3 page 792 dans lequel "les courants de contrôle sont asservis en phase et fréquence aux signaux de sortie d'un capteur de position" (page 791 dernières lignes et 792 première ligne). Là encore bien qu'il y ait une boucle de réaction, cette boucle n'est destiné qu'à corriger le courant de commande. La mesure de position du moteur n'est destinée qu'à injecter au bon moment des valeurs de correction en particulier pour supprimer les variations parasites de la valeur du couple dépendant de certains harmoniques du courant de commande. Il s'agit là encore de compensation dont les valeurs sont prédéterminées a priori.

Ceci a pour inconvénient le manque de précision et les aléas inhérents à ce genre de compensation a priori. Par ailleurs, cette façon de faire ne résoud nullement le problème de contrôle du couple du moteur.

Un second moyen, schématisé en traits mixtes sur la figure 1 précitée, consiste à associer à chaque amplificateur de puissance 18, 19, 20, une boucle de contre-réaction en courant, respectivement 21 (connexion de contre-réaction 24 et soustracteur d'entrée 25), 22 (connexion 26 et soustracteur 27), et 23 (connexion 28 et soustracteur 29). On réalise ainsi, sur chacune des trois phases, un asservissement en courant. Cette autre façon de faire, qui est souvent combinée avec la première, présente les inconvénients suivants :

. elle ne garantit pas une symétrie parfaite des trois chaînes d'amplification ;

. en cas d'avarie d'une des trois chaînes d'amplification, le moteur subit une dégradation de performances très importante ;

. elle ne permet pas d'obtenir une image réelle du couple, en particulier lors des relevés de mise au point.

L'invention vise à remédier à tous ces inconvénients. Elle se rapporte à cet effet à un dispositif de mesure dynamique du couple d'un moteur autosynchrone qui est équipé de moyens pour mesurer la valeur instantanée du courant dans chacun des enroulements statoriques de ce moteur, de moyens pour mesurer la valeur instantanée de l'angle entre la direction du champ magnétique respectif créé dans chacun de ces enroulements et l'axe perpendiculaire au moment magnétique (ou "APMM") de l'aimant que constitue le rotor de ce moteur, de moyens pour calculer le cosinus de chacun de ces angles respectifs et pour multiplier ce cosinus par ladite valeur instantanée du courant statorique correspondant afin d'obtenir ainsi la valeur arithmétique de la projection du vecteur représentant dans le plan électrique de la machine ce courant statorique respectif, sur ledit APMM, et enfin de moyens pour additionner les valeurs arithmétiques de ces projections ainsi obtenues et pour multiplier le résultat obtenu par un facteur de proportionnalité permettant d'obtenir alors la valeur instantanée du couple électromagnétique du moteur.

De toute façon, l'invention sera bien comprise, et ses avantages et autres caractéristiques ressortiront, lors de la description suivante d'un exemple non limitatif de réalisation pour moteur autosynchrone triphasé, en référence au dessin schématique annexé dans lequel :

- Figure 2 est un schéma explicatif du mode de calcul de couple dont il est fait usage dans la présente invention ;
- Figure 3 est un schéma électrique simplifié de ce dispositif de mesure du couple électromagnétique d'un moteur autosynchrone ;
- Figure 4 est un schéma électrique simplifié d'un dispositif de commande asservie de ce moteur autosynchrone, ce dispositif de commande utilisant le dispositif de mesure de couple selon la figure 3 ; et
- Figure 5 est une variante de ce dispositif de mesure de couple.

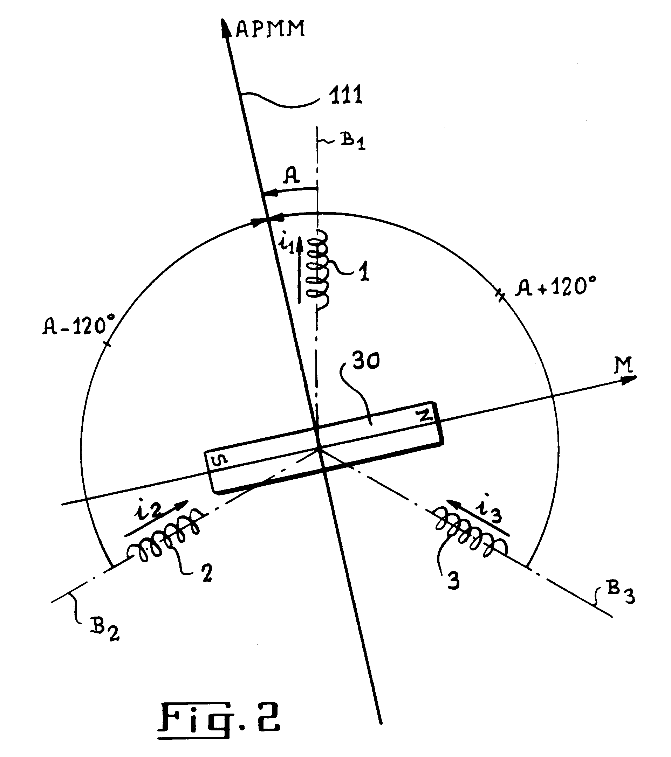

En se référant à la figure 2, il est représenté dans le plan électrique du moteur autosynchrone triphasé, les trois enroulements d'induit 1, 2, 3 dont les axes B1, B2, B3, qui donnent la direction des trois champs magnétiques instantanés et respectivement créés par les courants statoriques i1, i2, et i3, sont à 120 degrés l'un par rapport à l'autre.

Le rotor du moteur est symboliquement représenté par un aimant permanent 30 de moment magnétique M et l'APMM, qui par définition est l'axe orthogonal à ce moment magnétique M, est désigné par la référence 111.

A étant l'angle entre la direction B1 et l'APMM 111, il s'ensuit que les angles entre respectivement B2 et B3 et cet APMM sont respectivement égaux à (A-120°) et (A+120°), comme indiqué sur le dessin.

Le vecteur couple instantané, C1 créé par le courant i1 circulant dans l'enroulement 1 est, comme il est bien connu, égal au produit vectoriel du vecteur "moment magnétique" de l'aimant 30 par le vecteur "induction magnétique" engendré par ce courant i1. Par suite, ce couple C1 est proportionnel au produit de la valeur arithmétique de ce courant il par le cosinus de l'angle A entre la direction B1 du champ magnétique créé par le courant il dans l'enroulement 1 et la direction de l'APMM 111. Soit :

$$C1 = k.i1.\cos A$$

où k est un facteur de proportionnalité.

De la même façon, le couple C2 dû à la circulation du courant i2 dans l'enroulement 2 est égal à :

$$C2 = k.i2.\cos (A-120°)$$

et le couple C3 dû à la circulation du courant i3 dans l'enroulement 3 est égal à :

$$C3 = k.i3.\cos (A+120°)$$

de sorte que finalement la valeur arithmétique du couple électromagnétique instantané Ci sur l'arbre du moteur autosynchrone est donnée par la formule :

$$Ci = k[i1.\cos A + i2.\cos (A - 120°) + i3.\cos (A + 120°)]$$

C'est précisément de cette formule dont il est fait usage dans le dispositif de mesure de ce couple Ci qui sera maintenant décrit en référence à la figure 3.

En se reportant donc à cette figure 3, les trois enroulements statoriques du moteur autosynchrone, parcourus par les courants i1, i2, i3 fournis par un bloc électronique d'alimentation généralement référencé 34, sont là encore désignés par les références 1, 2, et 3. Comme c'est le cas pour le circuit classique de la figure 1, le bloc électronique 34 distribue les courants i1, i2, et i3, de façon que le champ électromagnétique instantané qu'ils créent à eux-trois dans les enroulements 1, 2, et 3, soit toujours parallèle à l'APMM précité, tout au moins pour les vitesses faibles.

Des capteurs analogiques de courant 31, 32, 33 qui sont respectivement placés en série avec les bobines 1, 2, et 3, fournissent sur leurs sorties respectives 41, 42, 43 des valeurs analogiques représentatives respectivement de a valeur arithmétique instantanée des courants i1, i2, i3.

Un codeur numérique 4, qui est placé sur l'arbre 84 du moteur autosynchrone, fournit sur son bus de sortie 35 une information digitale représentative de la valeur de l'angle A entre la direction du champ magnétique de l'enroulement 1 et l'APMM du moteur (voir figure 2).

Cette information numérique est respectivement appliquée aux entrées respectives 86, 87, 88 de trois circuits intégrés 38, 39, 40 de type SGS2716, qui sont respectivement programmés pour effectuer le calcul numérique de cos A, cos (A-120°), et cos (A+120°).

Les sorties de ces circuits de calcul 38, 39, 40 sont respectivement appliquées aux trois entrées numériques respectives 44, 45, 46 de trois circuits intégrés 47, 48, 49 de type AD7533, qui reçoivent sur leurs entrées analogiques respectives 50, 51 52 les sorties de mesure 41, 42, 43 des capteurs de courant 31, 32, 33 précités. Chacun de ces circuits intégrés 47, 48, 49 effectue la multiplication de la valeur analogique du courant i1, i2, i3 appliqué sur son entrée analogique 50, 51, 52 par la valeur analogique de l'information numérique cos A, cos (A-120°), cos (A+120°), qui est appliquée sur son entrée numérique 44, 45, 46.

Sur les sorties respectives 53, 54, 55 de ces circuits de calcul 47, 48, 49 sont par suite obtenues les valeurs analogiques respectives de i1.cos A, i2.cos (A-120°) et i3.cos (A+120°). Ces trois tensions sont appliquées, à travers des résistances 56, 57, 58 d'égales valeurs, à l'entrée inverseuse 59 d'un amplificateur différentiel 60 dont l'entrée non-inverseuse 61 est reliée à la masse par une résistance 62 : cet amplificateur 60 fonctionne en additionneur des trois tensions fournies en 53, 54, et 55, de sorte que, par le jeu d'une résistance classique 63 de réglage de gain, la tension obtenue sur sa sortie 64 est finalement égale à :

k [i1.cos A + i2.cos (A - 120°) + i3.cos (A + 120°)], c'est à dire finalement à la valeur instantanée Ci du couple sur l'axe du moteur.

La mesure Ci ainsi obtenue peut être utilisée à des fins diverses, comme par exemple pour effectuer des relevés de fonction de transfert en laboratoire ou dans les servomécanismes, ou pour effectuer des tests lors des essais de mise au point en laboratoire ou dans un servomécanisme. Elle peut aussi être utilisée, à l'instar des moteurs à courant continu classiques, pour réaliser une boucle de contre-réaction en courant dans le cadre d'une commande asservie d'un moteur autosynchrone.

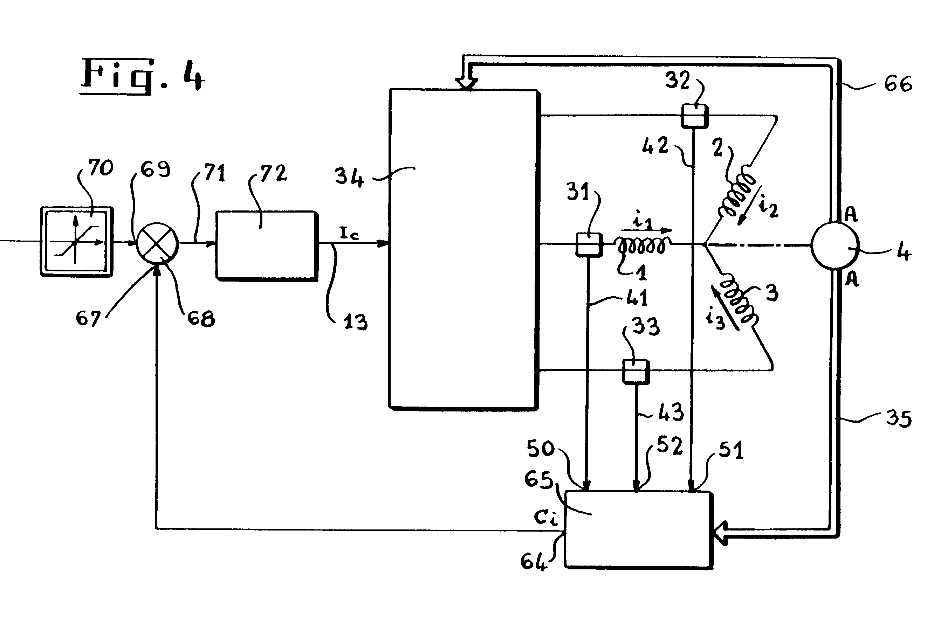

Un exemple de réalisation d'une telle commande asservie, avec boucle de contre-réaction en courant, est schématisé sur la figure 4 sur laquelle les éléments qui se retrouvent à l'identique dans les figures précédentes ont été indiqués par les mêmes chiffres de référence. En outre, dans un but de simplification, on a désigné par un seul bloc référencé 65 l'ensemble du circuit de calcul qui est encadré en traits mixtes sur la figure 3 (où il porte aussi la référence 65 pour la clarté de l'exposé).

Il convient de remarquer que le codeur angulaire 4 fournit aussi, par un bus 66, la valeur de l'angle A au bloc électronique 34. Ce dernier, à l'instar de celui qui est par analogie encadré en traits mixtes sur la figure 1 et également désigné par la référence 34, a en effet besoin de cette information pour réaliser la distribution souhaitée des courants i1, i2, i3 dans les enroulements statoriques 1, 2, 3.

Comme on le voit sur cette figure 4, la tension analogique Ci issue en 64 du bloc de calcul 65 est utilisée pour réaliser une boucle de contre-réaction, et est en conséquence appliquée sur l'entrée de soustraction 67 d'un soustracteur classique 68 qui reçoit sur son autre entrée 69 le signal de commande provenant par exemple d'un circuit de servomécanisme, et avantageusement passé auparavant dans un dispositif classique de saturation volontaire 70.

Le signal d'erreur obtenu en sortie 71 du soustracteur 68 est classiquement appliqué à un réseau correcteur 72 apte à pallier aux risques d'instabilité de l'ensemble, pour être finalement appliqué sur l'entrée 13 du bloc électronique 34 (voir par analogie la figure 1).

Il convient de remarquer que le bloc 34 peut comporter, sur ses amplificateurs de puissance 18, 19, 20 (voir la figure 1), des boucles de contre-réaction 21, 22, 23 qui auront pour avantage de renforcer les effets bénéfiques de la boucle globale de la figure 4. Toutefois, dans une solution de réalisation plus économique, on pourra s'abstenir de prévoir de telles boucles de contre-réaction 21 à 23. Dans un même ordre d'idées, il est aussi possible de prévoir également, dans une installation selon la figure 4, la compensation à priori évoquée précédemment.

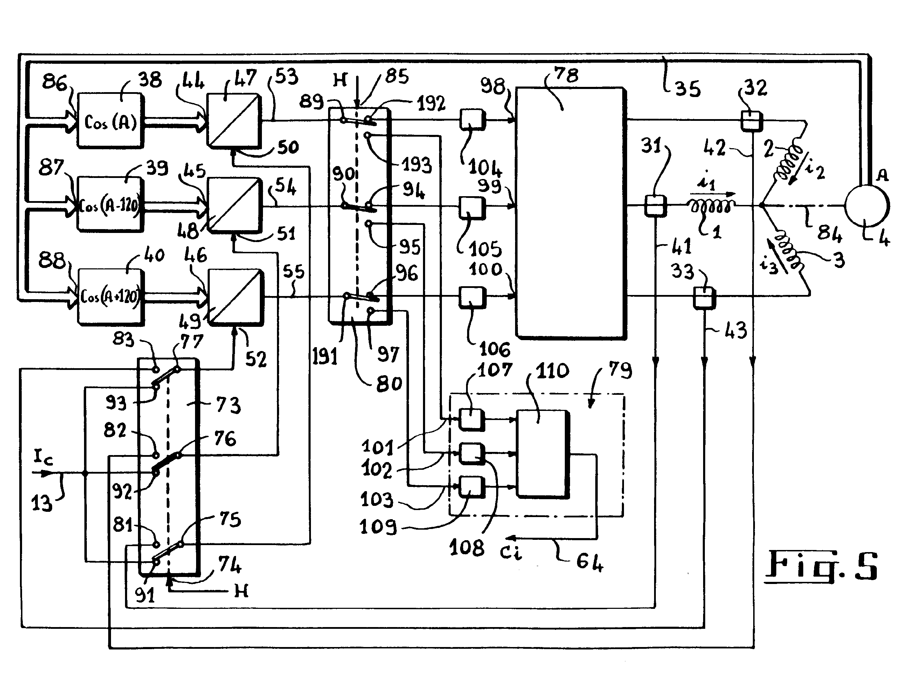

Une intéressante variante de ce dispositif de mesure du couple électromagnétique d'un moteur autosynchrone est schématisée sur la figure 5.

Cette réalisation se base sur la remarque que, dans un circuit selon la figure 3 par exemple, ce sont des éléments fonctionnels identiques qui peuvent être utilisés aussi bien, dans le bloc 65, pour le calcul de la valeur arithmétique de chacune des projections des vecteurs représentatifs des courants i1, i2, et i3 sur l'APMM du moteur (et donc pour le calcul du couple), que, dans le bloc 34, pour la décomposition du courant de commande Ic (se reporter aux explications relatives à la figure 1) sur les trois axes afin d'obtenir un champ résultant qui soit parallèle à l'APMM : dans un cas comme dans l'autre, il s'agit de calculer cos A, cos (A-120°), et cos (A+120°), et de multiplier chacune de ces valeurs obtenues par une valeur arithmétique.

En fin de compte, il est possible, comme le représente la figure 5, d'utiliser les circuits de calcul de i1.cos A, i2.cos (A-120°), et i3.cos (A+120°), c'est à dire par exemple les circuits respectifs (38,47), (39,48), et (40,49), aussi bien dans le bloc 65 que dans le bloc 34, et d'opérer par multiplexage pour utiliser ces circuits alternativement pour l'un ou l'autre bloc.

Sur cette figure 5, le bus 35 achemine, comme sur la figure 3, l'information numérique représentative de la valeur instantanée de l'angle A précité vers les circuits 38, 39, 40 (les mêmes que sur cette figure 3) de calcul numérique de cos A, cos (A-120°), et cos (A+120°). Les informations numériques en sortie de ces trois circuits sont appliquées, toujours comme dans la figure 3, aux multiplieurs hybrides (numérique/analogique) 47, 48 et 49, sur les entrées numériques respectives 44, 45, et 46, de ces multiplieurs.

Les sorties 41, 42, 43 des capteurs de courant 31, 32, 33, sont respectivement reliées aux trois premières bornes d'entrées 81, 82, 83 d'un premier circuit électronique de commutation, ou multiplexeur, 73 qui est commandé en 74 par un signal d'horloge H.

Ce multiplexeur 73 reçoit sur ces trois secondes bornes d'entrée correspondantes 91, 92, 93, le paramètre de commande du moteur Ic qui est appliqué sur le fil 13 (ainsi référencé par souci d'analogie avec le circuit de la figure 1).

Le multiplexeur 73 fonctionne, sous commande du signal de commutation H, comme un ensemble de trois commutateurs à deux voies, dont les trois sorties commutées respectives 75, 76, 77 sont appliquées aux entrées analogiques respectives 50, 51, 52 des multiplieurs hybrides 47, 48, 49.

Il apparaît donc clairement que si, sur un coup d'horloge déterminé, les trois commutateurs sont dans la position de la figure 5, et que par suite c'est la valeur Ic qui est appliquée sur les entrées analogiques 50, 51, 52 des multiplieurs 47, 48, 49, en revanche, au coup d'horloge suivant qui fait basculer ces trois commutateurs dans leur autre position, ce sont les valeurs mesurées par les capteurs 31, 32, 33 des courants i1, i2, i3 qui sont respectivement appliquées sur ces trois entrées des multiplieurs 47, 48, 49. Dans cette première position, on obtient alors les valeurs respectives Ic.cos A, Ic.cos (A-120°) et Ic.cos (A+120°), sur les sorties 53, 54, 55 de ces multiplieurs 47, 48, 49, tandis que dans cette deuxième position, ce sont les valeurs respectives i1.cos A, i2.cos (A-120°), et i3 (A+120°), qui sont obtenues sur ces mêmes sorties 53, 54 et 55 : on utilise donc bien les mêmes circuits 38/47, 39/48, 40/49, pour effectuer de manière alternée ces deux calculs.

Afin d'aiguiller les données analogiques alternativement obtenues en 53, 54, 55, alternativement vers le circuit 78 d'alimentation en puissance du moteur d'une part, et vers la partie restante 79 du circuit de mesure de couple d'autre part, il est prévu un second commutateur électronique de multiplexage 80, commandé par le signal d'horloge H précité sur son entrée de commande 85 et possédant (à l'inverse du multiplexeur 73) trois bornes d'entrée 89, 90, 191, et six bornes de sortie commutée respectivement associées deux à deux à ces trois bornes d'entrée, dont :

. 192 et 193 associées à la borne d'entrée 89 ;

. 94 et 95 associées à la borne d'entrée 90 ; et

. 96 et 97 associées à la borne d'entrée 191.

Les bornes d'entrée 89, 90, 191 étant reliées aux sorties 53, 54, 55 des multiplieurs 47, 48, 49, le multiplexeur 80 est réglé pour relier entre elles respectivement les bornes 89 et 192, 90 et 94, 191 et 96 lorsque ce sont (cas de la figure 5), les bornes 93 et 77, 92 et 76, 91 et 75, du multiplexeur 73 qui sont reliées entre elles, et à contrario pour relier entre elles les bornes 89 et 193, 90 et 95, 191 et 97, dans le cas contraire.

Dans ce premier cas, les sorties 53, 54, 55 sont connectées aux entrées 98, 99, 100 du circuit de puissance 78, ce qui assure l'alimentation souhaitée des enroulements statoriques 1, 2, 3, et, dans ce deuxième cas (c'est à dire au coup d'horloge suivant), elles sont connectées aux trois entrées 101, 102, 103 du bloc 79 précité, ce qui permet le calcul du couple Ci, dont la valeur apparaît sur le fil de sortie 64.

Il est à noter que trois circuits bloqueurs 104, 105, et 106 sont respectivement prévus respectivement en amont des trois entrées précitées 98, 99, 100 du circuit de puissance 78, pour éviter une perte du signal pendant l'intervalle de temps où les bornes 89, 90 et 91 sont respectivement connectées aux bornes 193, 95, et 97. De la même façon, les entrées 101 à 103 du circuit 79 sont respectivement appliquées à des circuits bloqueurs 107 à 109 pour éviter une perte d'information de calcul du couple Ci pendant l'intervalle de temps suivant où les bornes 89, 90 et 91 sont respectivement connectées aux bornes 192, 94, et 96.

Les signaux de sortie de ces trois bloqueurs 107 à 109 sont appliqués respectivement à un additionneur à amplificateur opérationnel 110 qui, à l'instar du circuit 56 à 63 de la figure 3, les additionne et les multiplie par un facteur de proportionnalité pour en déduire la valeur Ci du couple, qui est extraite en 64.

Comme il va de soi, l'invention n'est pas limitée aux exemples de réalisation qui viennent d'être décrits. C'est ainsi que le circuit câblé 65 (figures 3 et 4) qui effectue le calcul du couple Ci par application de la formule :

$$Ci = k [i1.cos A + i2.cos (A - 120°) + i3.cos (A + 120°)]$$

pourrait être remplacé par un microprocesseur, par exemple du genre "Digital Signal Processor" ou "DSP" ou pour tout autre dispositif logique de calcul. Plus précisément, c'est un DSP déjà utilisé par ailleurs dans le servomécanisme dont fait partie le moteur qui pourrait aussi réaliser cette fonction. Dans un tel cas, l'utilisation, selon la figure 5, des mêmes éléments fonctionnels aussi bien pour réaliser la décomposition du vecteur Ic (paramètre de commande) selon les trois axes des bobinages statoriques du moteur que pour effectuer l'élaboration sous la forme d'un signal analogique ou numérique de la variable Ci par l'addition des trois projections sur l'APMM des trois courants statoriques, serait simplement réalisée par l'utilisation des mêmes sous-programmes. On a donné ci-dessus l'exemple d'un moteur à trois phases (1, 2, 3), il va de soi qu'il pourrait s'agir d'un moteur diphasé ou d'un moteur à plus de trois phases.

## Revendications

1. Dispositif de mesure dynamique du couple ($C_i$) d'un moteur autosynchrone, le moteur comportant un rotor formé par un aimant permanent (30) auquel est associé un axe (111) perpendiculaire au moment magnétique (APMM) de cet aimant, des enroulements (1, 2, 3) de stator, chaque enroulement (1, 2, 3) de stator recevant par un moyen électronique d'alimentation un courant d'alimentation, le moteur comportant également des moyens (31, 32, 33) pour mesurer la valeur instantanée d'au moins un angle (A, A+120°, A-120°) entre la direction du champ magnétique respectif ($B_1$, $B_2$, $B_3$) crée dans l'un de ces enroulements (1, 2, 3) et l'axe (111), associé au rotor (30), dispositif caractérisé en qu'il comporte en outre des moyens (38 à 40) pour calculer le cosinus de chacun des angles (A, A+120°, A-120°) entre l'axe (111) associé au rotor (30) et la direction du champ magnétique dans chacun des enroulements (1, 2, 3) du stator, et pour multiplier ce cosinus par la valeur instantanée (i1, i2, i3) du courant statorique correspondant afin d'obtenir la valeur arithmétique de la projection sur l'APMM (111) du vecteur représentant, dans le plan électrique de la machine, ce courant statorique respectif, et enfin des moyens (56 à 63) pour additionner les valeurs arithmétique [i1.cos A, i2.cos (A-120°), i3.cos (A+120°) ainsi obtenues de ces projections et pour multiplier le résultat obtenu par un facteur de proportionnalité (k) déterminé pour obtenir alors la valeur instantanée (Ci) du couple électromagnétique du moteur.

2. Dispositif de mesure dynamique du couple d'un moteur autosynchrone selon la revendication 1, caractérisé en ce qu'il comporte :
   . un dispositif (4) de codage numérique de l'angle (A) entre l'un des enroulements statoriques (1) et l'APMM (111);
   . autant de dispositifs (38, 39, 40) de calcul du cosinus desdits angles respectifs (A, A-120°, A-120°) qu'il y a de bobinage statoriques (1, 2, 3), c'est à dire de phases du moteur
   . autant de capteurs (31, 32, 33) de courants statoriques (i1, i2, i3) qu'il y a de phases (1, 2, 3) du moteur;
   . autant de circuits de multiplication numérique/analogique (47, 48, 49) qu'il y a de phases du moteur, chacun de ces circuits recevant sur son entrée (44, 45, 46) de signal numérique le signal de sortie du dispositif de calcul de cosinus correspondant (38, 39, 40) et sur son entrée (50, 51, 52) de signal analogique, le signal de sortie du capteur de courant correspondant (31, 32, 33); et
   . un circuit (56 à 63) d'addition analogique avec multiplication du résultat obtenu par un facteur de proportionnalité.

3. Dispositif de mesure dynamique du couple d'un moteur selon la revendication 1, caractérisé en ce qu'il comporte un dispositif logique de calcul apte à réaliser lesdits calculs de cosinus, lesdites multiplications par les valeurs instantanées (i1, i2, i3) des courants statoriques, et ladite addition avec multiplication par ledit facteur de proportionnalité (k).

4. Dispositif de mesure dynamique du couple d'un moteur autosynchrone selon l'une des revendications 1 à 3, caractérisé en ce qu'il comporte des moyens de multiplexage (73, 80) aptes à permettre l'utilisation alternée de mêmes éléments fonctionnels (38 à 40, 47 à 49) aussi bien pour réaliser la répartition des courants statoriques (i1; i2, i3) du moteur que pour réaliser le calcul de la valeur instantanée (Ci) du couple du moteur.

5. Dispositif de commande asservie d'un moteur autosynchrone faisant usage d'un dispositif de mesure dynamique selon l'une des revendications 1 à 4, caractérisé en ce que ce dispositif de mesure (4, 31 à 33, 65) est inséré dans une boucle de contre-réaction en courant (64, 65, 68) pour fournir le signal de commande (Ic) au circuit (34) d'alimentation en puissance du moteur.

**Patentansprüche**

1. Vorrichtung zur dynamischen Messung des Drehmoments (Ci) eines autosynchronen Motors, der einen von einem Dauermagneten (30) gebildeten Rotor mit einer Achse (111) senkrecht zum Magnetmoment (APMM) dieses Magneten, Statorwicklungen (1, 2, 3), die von einem elektronischen Speisemittel einen Speisestrom erhalten, weiter Mittel (31, 32, 33) zur Messung des Augenblickswerts mindestens eines Winkels (A, A+120°, A-120°) zwischen der Richtung des Magnetfelds (B1, B2, B3) in einer dieser Wicklungen (1, 2, 3) und der dem Rotor (30) zugeordneten Achse enthält, dadurch gekennzeichnet, daß die Vorrichtung weiter Mittel (38 bis 40) enthält, um den Cosinus jedes der Winkel (A, A+120°, A-120°) zwischen der dem Rotor (30) zugeordneten Achse (111) und der Richtung des Magnetfelds in jeder Wicklungen (1, 2, 3) des Stators zu berechnen und um diesen Cosinus mit dem Augenblickswert (i1, i2, i3) des entsprechenden Statorstroms zu multiplizieren, so daß sich der arithmetische Wert der Projektion des Vektors, der in der elektrischen Ebene der Maschine diesen jeweiligen Statorstrom repräsentiert, auf die APMM-Achse (111) ergibt, und daß weiter Mittel (56 bis 63) vorgesehen sind, um die so erhaltenen arithmetischen Werte [i1.cos A, i2.cos (A-120°), i3.cos (A+120°)] dieser Projektionen zu addieren und das erhaltene Ergebnis mit einem bestimmten Proportionalitätsfaktor (k) zu multiplizieren, so daß sich der Augenblickswert (Ci) des elektromagnetischen Drehmoments des Motors ergibt.

2. Vorrichtung zur dynamischen Messung des Moments eines autosynchronen Motors nach Anspruch 1, dadurch gekennzeichnet, daß sie enthält:
   . eine Vorrichtung (4) zur digitalen Kodierung des Winkels (A) zwischen einer der Statorwicklungen (1) und der APMM-Achse (111);
   . ebensoviele Vorrichtungen (38, 39, 40) zur Berechnung des Cosinus der jeweiligen Winkel (A, A-120°, A+120°), wie Statorwicklungen (1, 2, 3) oder Motorphasen vorhanden sind,
   . ebensoviele Sonden (31, 32, 33) zur Messung des Statorstroms (i1, i2, i3), wie es Phasen (1, 2, 3) des Motors gibt;
   . ebensoviele digitale/analoge Multiplizierkreise (47, 48, 49), wie es Motorphasen gibt, wobei jeder dieser Kreise an seinem digitalen Signaleingang (44, 45, 46) das Ausgangssignal der entsprechenden Vorrichtung (38, 39, 40) zur Berechnung des Cosinus und an seinem analogen Signaleingang (50, 51, 52) das Ausgangssignal der entsprechenden Stromsonde (31, 32, 33) empfängt,

. und einen Kreis (56 bis 63) zur analogen Addition und Multiplikation des erhaltenen Ergebnisses mit einem Proportionalitätsfaktor.

3. Vorrichtung zur dynamischen Messung des Drehmoments eines Motors nach Anspruch 1, dadurch gekennzeichnet, daß sie eine logische Rechenvorrichtung aufweist, die die Cosinusberechnungen, die Multiplikation mit den Augenblickswerten (i1, i2, i3) der Statorströme und die Addition und nachfolgende Multiplikation mit dem Proportionalitätsfaktor (k) durchführen kann.

4. Vorrichtung zur dynamischen Messung des Drehmoments eines autosynchronen Motors nach einem der Ansprüche 1 bis 3, dadurch gekennzeichnet, daß sie Multiplexiermittel (73, 80) aufweist, die die abwechselnde Verwendung der gleichen Funktionselemente (38 bis 40, 47 bis 49) sowohl für die Verteilung der Statorströme (i1, i2, i3) des Motors als auch für die Berechnung der Augenblickswerte (Ci) des Motordrehmoments zulassen.

5. Regelvorrichtung für einen autosynchronen Motor, der eine Vorrichtung zur dynamischen Messung nach einem der Ansprüche 1 bis 4 verwendet, dadurch gekennzeichnet, daß diese Meßvorrichtung (4, 31 bis 33, 65) in eine Stromrückkopplungsschleife (64, 65, 68) eingefügt ist, um das Steuersignal (Ic) an die Leistungsspeiseschaltung (34) des Motors zu liefern.

**Claims**

1. Device for dynamically measuring the torque (Ci) of an autosynchronous motor, the motor including a rotor formed by a permanent magnet (30) with which an axis (111) perpendicular to the magnetic moment (APMM) of this magnet is associated, stator windings (1, 2, 3), each stator winding (1, 2, 3) receiving a supply current via an electronic supply means, the motor also including means (31, 32, 33) for measuring the instantaneous value of at least one angle (A, A+120°, A-120°) between the direction of the respective magnetic field ($B_1$, $B_2$, $B_3$) created in one of these windings (1, 2, 3) and the axis (111), associated with the rotor (30), which device is characterized in that it furthermore includes means (38 to 40) for calculating the cosine of each of the angles (A, A+120°, A-120°) between the axis (111) associated with the rotor (30) and the direction of the magnetic field in each of the windings (1, 2, 3) of the stator, and for multiplying this cosine by the instantaneous value (i1, i2, i3) of the corresponding stator current so as to obtain the arithmetic value of the projection on the APMM (111) of the vector representing this respective stator current in the electric plane of the machine, and, finally, means (56 to 63) for adding the arithmetic values [i1 . cos A, i2 . cos (A-120°), i3 . cos (A+120°)] thus obtained of these projections and for multiplying the result obtained by a predetermined proportionality factor (k) in order then to obtain the instantaneous value (Ci) of the electromagnetic torque of the motor.

2. Device for dynamically measuring the torque of an autosynchronous motor according to Claim 1, characterized in that it includes:

. a device (4) for digitally encoding the angle (A) between one (1) of the stator windings and the APMM (111);

. as many devices (38, 39, 40) for calculating the cosine of the said respective angles (A, A+120°, A-120°) as there are stator windings (1, 2, 3), that is to say as there are phases of the motor;

. as many sensors (31, 32, 33) for sensing the stator currents (i1, i2, i3) as there are phases (1, 2, 3) of the motor;

. as many digital-to-analog multiplication circuits (47, 48, 49) as there are phases of the motor, each of these circuits receiving, on its digital-signal input (44, 45, 46), the output signal from the corresponding cosine-calculating device (38, 39, 40) and, on its analog-signal input (50, 51, 52), the output signal from the corresponding current sensor (31, 32, 33); and

. an analog addition circuit (56 to 63) with multiplication of the result obtained by a proportionality factor.

3. Device for dynamically measuring the torque of a motor according to Claim 1, characterized in that it includes a calculating logic device capable of carrying out the said cosine calculations, the said multiplications by the instantaneous values (i1, i2, i3) of the stator currents, and the said addition with multiplication by the said proportionality factor (k).

4. Device for dynamically measuring the torque of an autosynchronous motor according to one of Claims 1 to 3, characterized in that it includes multiplexing means (73, 80) capable of allowing the alternating use of the same functional elements (38 to 40, 47 to 49) both for carrying out the distribution of the stator currents (i1, i2, i3) of the motor and for carrying out the calculation of the instantaneous value (Ci) of the torque of the motor.

5. Device for the feedback control of an auto-synchronous motor making use of a dynamic measuring device according to one of Claims 1 to 4, characterized in that this measuring device (4, 31 to 33, 65) is inserted into a negative current feedback loop (64, 65, 68) in order to furnish the control signal (Ic) to the circuit (34) for supplying power to the motor.

Fig.1

**Fig.2**

**Fig. 3**

Fig. 4

Fig.5